(19) **Europäisches Patentamt**

**European Patent Office**

**Office européen des brevets**

(11) **EP 1 166 448 B1**

(12) **EUROPÄISCHE PATENTSCHRIFT**

(45) Veröffentlichungstag und Bekanntmachung des Hinweises auf die Patenterteilung:
**03.12.2003 Patentblatt 2003/49**

(21) Anmeldenummer: **00929281.4**

(22) Anmeldetag: **05.04.2000**

(51) Int Cl.$^7$: **H03M 13/23**

(86) Internationale Anmeldenummer:
**PCT/DE00/01055**

(87) Internationale Veröffentlichungsnummer:
**WO 00/062425 (19.10.2000 Gazette 2000/42)**

(54) **VERFAHREN ZUR KANALCODIERUNG**

METHOD FOR CODING CHANNELS

CODAGE DE CANAL

(84) Benannte Vertragsstaaten:
**DE FR GB IT**

(30) Priorität: **07.04.1999 DE 19915687**

(43) Veröffentlichungstag der Anmeldung:
**02.01.2002 Patentblatt 2002/01**

(73) Patentinhaber: **SIEMENS AKTIENGESELLSCHAFT**
**80333 München (DE)**

(72) Erfinder:
• **HINDELANG, Thomas**
  **D-81373 München (DE)**
• **STOCKHAMMER, Thomas**
  **D-83346 Bergen (DE)**
• **XU, Wen**
  **D-82008 Unterhaching (DE)**

(56) Entgegenhaltungen:
• **F. BURKERT ET AL.: "Turbo Decoding with Unequal Error Protection applied to GSM speech coding" GLOBECOM. IEEE GLOBAL TELECOMMUNICATIONS CONFERENCE AND EXHIBITION, Nr. 3, 18. November 1996 (1996-11-18), Seiten 2044-2048, XP002133421 US, New York**

**Beschreibung**

Die Erfindung betrifft ein Verfahren zur Kanalcodierung in einem digitalen Nachrichtenübertragungssystem nach dem Oberbegriff des Anspruchs 1.

Moderne digitale Nachrichtenübertragungssysteme sehen eine Quellencodierung von Signalen (z.B. Sprachen) vor, mit der eine Kompression des Signals erreicht wird, so daß zur Übertragung eine wesentlich geringere Bitrate ausreicht, als sie das (primäre) digitale Signal aufweist. So wird gemäß dem Systemstandard des allgemein bekannten GSM-Mobilfunksystems das Sprachsignal senderseitig mit einer Rate von 8000 Abtastwerten pro Sekunde abgetastet, wobei die Abtastwerte mit einer Auflösung von 13 Bit dargestellt werden. Das entspricht einer Bitrate von 104 kbit/s je Sprachsignal. Der Quellen- bzw. Sprachcoder komprimiert dieses Sprachsignal zu einem quellenkodierten Sprachsignal mit Blöcken von 260 Bit Länge und einer Bitrate von 13 kbit/s. Hier findet also eine Kompression der Sprachsignale um den Faktor 8 statt.

Die physikalischen Gegebenheiten bei einer drahtlosen Nachrichtenübertragung, speziell in den für Mobilfunksystemen verfügbaren Frequenzbereichen unter terrestrischen Bedingungen, bei denen eine vielfältige Streuung und Reflexion an natürlichen Hindernissen stattfindet, führen zu hohen und relativ stark schwankenden Ausbreitungsverlusten und durch Mehrwegeausbreitung erzeugtem Schwund (fast fading). In einzelnen Zeitabschnitten (Zeitschlitzen) des Übertragungsvorgangs kann die Übertragung aufgrund dessen stark gestört oder sogar ganz unterbrochen sein, während andere Zeitschlitze hingegen kaum gestört sind.

Der Nutzdatenstrom umfaßt daher Phasen, die entweder eine hohe oder niedrigere Bitfehlerhäufigkeit aufweisen, d. h. die Fehler treten insbesondere gebündelt auf.

Aufgrund dieser Umstände wäre die Übertragung des durch die Quellencodierung hochkomprimierten und redundanzgeminderten Sprachsignals nicht ohne weiteres in akzeptabler Qualität möglich. Die zu erwartende Bitfehlerhäufigkeit (in einer Größenordnung von $10^{-3}$ bis $10^{-1}$) ist daher durch geeignete Fehlerkorrekturverfahren auf akzeptable Werte (in der Größenordnung $10^{-3}$ bis $10^{-6}$) zu verringern. Hierin besteht die Aufgabe der Kanalcodierung, die den quellenkodierten Signalen im Grunde wieder eine - definierte - Redundanz hinzufügt, die dann die Erkennung und Korrektur von Übertragungsfehlern auf der Übertragungsstrecke (Luftschnittstelle) erlaubt.

Bei dem gattungsgemäßen Verfahren umfaßt die Kanalcodierung eine Fehlerschutzcodierung (Faltungscodierung) und eine Verschachtelung (Interleaving, auch als Verwürfelung bezeichnet). Anschließend werden die faltungscodierten und verschachtelten Blöcke verschlüsselt, auf Bursts abgebildet, der Trägerfrequenz aufmoduliert und übertragen.

Für die Faltungscodierung ist zu beachten, daß die quellencodierten Bits nicht von gleicher Relevanz für die Sprachqualität nach der Decodierung sind. Fehler in manchen Bits führen zu erheblichen Beeinträchtigungen der Verständlichkeit, Fehler in anderen Bits sind dagegen kaum wahrnehmbar. Die quellencodierten Bits sind daher in Klassen eingeteilt, für die ein unterschiedlicher Fehlerschutz vorgesehen wird. So gibt es beim GSM-Vollratencodec (Codierer/ Decodierer für die Vollratenübertragung) die Schutzklassen 1a, 1b und 2.

Eine übliche Methode zur Realisierung dieses unterschiedlichen Schutzes ist die sogenannte Punktierung des Codes im Anschluß an die Fehlerschutzcodierung (Faltungscodes). Durch die Punktierung werden - vereinfacht gesagt - aus dem Ausgangsbitstrom des Faltungscodierers nach einem vorgegebenen Schema (einer Punktierungstabelle) eine oder mehrere Stellen herausgestrichen. Eine Punktierungstabelle besteht aus den Elementen 0 und 1 und wird periodisch abgearbeitet, wobei das einer 0 entsprechende Bit im Ausgangsbitstrom nicht gesendet wird und das einer 1 entsprechende Bit gesendet wird. Die codierte Sequenz wird folglich verkürzt und die Fehlerschutzwirkung geschwächt. Punktierte Codes haben allerdings den Vorteil der Realisierbarkeit verschiedener Codierraten, wobei ausgehend von einem Muttercode der Rate 1/n durch periodisches Punktieren Codes mit höherer Coderate entwickelt werden.

Die grundsätzliche Empfindlichkeit der Faltungscodier- und Decodierverfahren gegenüber bündelartig auftretenden Fehlern, wie sie bei Mobilfunkverbindungen das Hauptproblem darstellen, wird durch die Punktierung noch verschärft, so daß punktierte Faltungscodes praktisch nur im Zusammenhang mit einem nachfolgenden Verschachteln bzw. Interleaving angewandt werden. Bei typischen Mobilfunkkanälen mit den Profilen TU (Typical Urban) oder HT (Hilly Terrain) im GSM-System oder in ähnlich profilierten Kanälen tritt innerhalb eines Zeitschlitzes eine annähernd konstante Fadingamplitude auf. Wird für jeden neuen Zeitschlitz ein anderer Kanal verwendet (ideal frequency hopping), kann die Fadingamplitude als statistisch unabhängig zwischen zwei Zeitschlitzen angenommen werden. Hierfür kommen als Verschachtelungsverfahren beispielsweise das Blockinterleaving oder Random-Interleaving in Frage, die dem Fachmann als solche bekannt sind.

Die Bestimmung guter punktierter Faltungscodes stellt ebenso eine wichtige Entwurfsaufgabe für ein digitales Nachrichtenübertragungssystem der oben skizzierten Art dar wie die Wahl und konkrete Ausgestaltung des nach der Fehlerschutzcodierung anzuwendenden Verschachtelungsverfahrens. Systematische konstruktive Verfahren sind hierfür nicht bekannt, so daß zur Auffindung guter punktierter Faltungscodes rechnergestützt verschiedene Codes und Punktierungen getestet und anhand bestimmter Kriterien, die eine Aussage über die voraussichtliche Übertragungsqualität erlauben, miteinander verglichen werden. Dabei wird üblicherweise der Interleaver als Ideal ("unendlich tief") vorausgesetzt.

Aus Globecom. Ieee Global Telecommunications Conference and Exhibition (18-1-1996), (3), 2044-2048, CP2133421 ist ein Dekodierungs- und Fehlerschutzverfahren zum Einsatz bei der Sprachkodierung in einem GSM-System der oben erwähnten Art bekannt.

Der Erfindung liegt die Aufgabe zugrunde, ein hinsichtlich der erzielbaren Übertragungsqualität verbessertes Verfahren zur Kanalcodierung anzugeben.

Diese Aufgabe wird durch ein Verfahren mit den Merkmalen des Anspruchs 1 gelöst.

Die Erfindung schließt den wesentlichen Gedanken ein, bei der Kanalcodierung eine zusammenhängende, in einem gemeinsamen Berechnungsschritt bestimmte Punktierungs- und Verschachtelungsvorschrift zur Punktierung eines Fehlerschutzcodierungs-Muttercodes und für ein Interleaving anzuwenden. Bei der Ermittlung dieser zusammenhängenden Punktierungs- und Verschachtelungsvorschrift wird von der Annahme eines idealen Interleavers abgegangen und die Gestaltung des Verschachtelungsschrittes von vornherein in einen unauflöslichen Zusammenhang mit der Auffindung einer vorteilhaften Punktierungsvorschrift (Generatormatrix oder Punktierungstabelle) gestellt.

Die Punktierungs- und Verschachtelungsvorschrift ist insbesondere in einer vorbestimmten Menge von Untercodes bzw. Punktierungstabellen oder auch einer kombinierten Punktierungs- und Verschachtelungsmatrix bzw. -tabelle zusammengefaßt. Deren Auffindung erfolgt rechnergestützt unter Beachtung des Kriteriums der Optimierung der Distanzeigenschaften, speziell der minimalen freien Distanz und/oder des mittleren Distanzspektrums. Diese Begriffe sind wie folgt zu verstehen:

- Die minimale freie Distanz $d_f$ eines Codes ist die minimale Hammingdistanz, die zwischen divergierenden Pfaden auftritt.
- Das mittlere Distanzspektrum $\{a_d\}$ ist gegeben durch $\{a_d\} = {}^1/_P \Sigma^\infty d=d_f a_d$ , wobei $a_d$ die Anzahl aller Pfade ist, die ausgehend von $P$ aufeinanderfolgenden Knoten den Nullpfad verlassen, sich wieder treffen und dabei die Distanz $d$ aufbauen, und $P$ die Anzahl der Spalten in der Punktierungsmatrix **P** ist und somit die Periodenlänge der Punktierung angibt.
- Das mittlere Distanzspektrum $\{c_d\}$ ist gegeben durch $\{c_d\} = {}^1/_P \Sigma^\infty d=d_f c_d$ , wobei das Informationsgewicht $c_d$ die Zahl der Bits mit dem Wert 1 entlang aller Pfade ist, die ausgehend von $P$ aufeinanderfolgenden Knoten den Nullpfad verlassen, wieder treffen und dabei die Distanz $d$ aufbauen.

Aus den Distanzspektren kann für einen AWGN (<u>A</u>dditive <u>W</u>hite <u>G</u>aussian <u>N</u>oise)-Kanal oder einen fully-interleaved Rayleighkanal die Bitfehlerwahrscheinlichkeit geschätzt werden. Die optimalen nichtsystematischen nichtrekursiven Faltungscodes und systematischen rekursiven Faltungscodes für die Übertragung ohne Punktierung bei Rate ½ und Gedächtnis 2 über die oben genannten Kanäle sind bekannt.

Es wird also in der Praxis in einer Mehrzahl von Berechnungsschritten mit dem Computer nach einer Mehrzahl von Algorithmen eine Mehrzahl von Punktierungs- und Verschachtelungsmatrizen bzw. -tabellen bestimmt, in einem Bewertungsschritt werden jeweils deren Distanzeigenschaften nach den genannten Teil-Kriterien ermittelt, und es wird diejenige Punktierungsund Verschachtelungsmatrix oder -tabelle im Kanalcodierer implementiert, die das im Hinblick auf die zu erwartende Bitfehlerrate günstigste Ergebnis zeigt.Besonders vorteilhaft ist die Anwendung des vorgeschlagenen Verfahrens bei einem Übertragungskanal des weiter oben erwähnten Profils, d. h. mit annähernd konstanter Fadingamplitude innerhalb eines Zeitschlitzes, und auf ein Übertragungsverfahren, bei dem jedem neuen Zeitschlitz ein anderer Kanal zugeordnet wird. Die Vorteile kommen besonders zum Tragen bei Anwendung auf ein Sprachübertragungsverfahren mit hoher Übertragungsrate. Bei diesem Verfahren wird davon ausgegangen, daß der Ausfall eines Zeitschlitzes das am häufigsten auftretende Fehlerereignis ist. Dies haben Untersuchungen auch bestätigt.

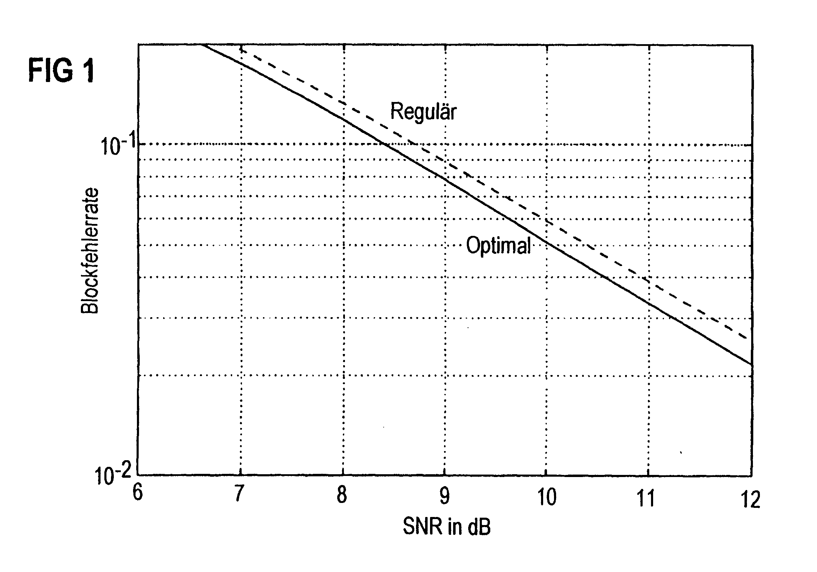

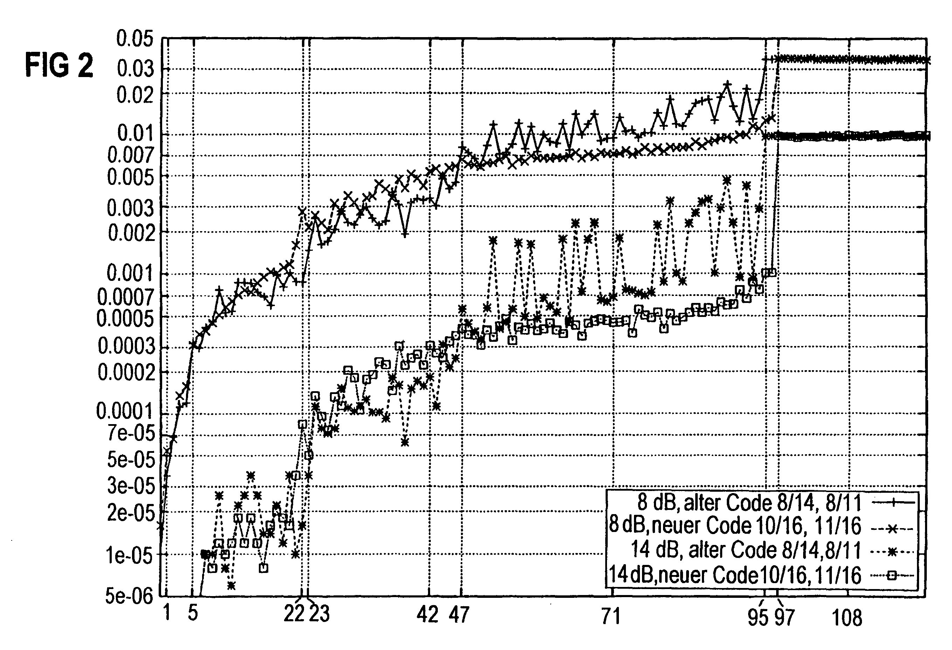

Nachfolgend soll die Erfindung an einem Ausführungsbeispiel näher erläutert werden, wobei sie einer herkömmlichen Lösung gegenüber gestellt wird. Aus dieser Beschreibung im Zusammenhang mit den Figuren 1 und 2, die als vergleichende Diagramme die erzielbare Verbesserung der Übertragungseigenschaften illustrieren, werden weitere Vorteile und Zweckmäßigkeiten der Erfindung deutlich.

Durch die Punktierung eines Muttercodes der Rate ½ und Gedächtnis $m$=4 mit den Generatorpolynomen

$$G = \left[ 1 \frac{D^4 + D^2 + D + 1}{D^4 + D^3 + 1} \right]$$

$$(3.1)$$

entsteht ein systematischer, punktierter Code der Rate $R$=11/16. Die mittels Rechnersuche gefundene Punktierungsmatrix mit den besten Distanzeigenschaften lautet:

$$P = \begin{bmatrix} 1 & 1 & 1 & 1 & 1 & 1 & 1 & 1 & 1 & 1 & 1 \\ 1 & 0 & 1 & 0 & 1 & 0 & 1 & 0 & 1 & 0 & 0 \end{bmatrix}$$

$$(3.2)$$

Die Periodenlänge P beträgt in diesem Beispiel 11. Bei der Auswahl der punktierten Codes ist darauf zu achten, daß die Zahl $Z$ der Einsen in der Punktierungsmatrix ein ganzzahliges Vielfaches der Zeitschlitze ist, um jedem Zeitschlitz die gleiche Anzahl an Bits zuordnen zu können. Das Interleaving ordnet die Bits der Matrix **P** den Zeitschlitzen zu. Im Beispiel wird der Halbratenkanal angenommen, und somit werden die $Z$=16 Bits auf $F$=4 Zeitschlitze aufgeteilt. Wird Blockinterleaving (üblicher unabhängiger Interleaver) angewandt, so erhält man folgende kombinierte Punktierungs- und Interleavingmatrix:

$$P = \begin{bmatrix} 1 & 3 & 4 & 2 & 3 & 1 & 2 & 4 & 1 & 3 & 4 \\ 2 & 0 & 1 & 0 & 4 & 0 & 3 & 0 & 2 & 0 & 0 \end{bmatrix}$$

$$(3.3)$$

Elemente der Matrix mit dem Wert 0 sind punktierte Bits, die Werte 1..4 ordnen die einzelnen Bits den entsprechenden Zeitschlitzen zu.

Der Ausfall eines Blockes kann nun wie eine weitere Punktierung betrachtet werden, d. h. alle Bits dieses Blockes werden ignoriert. Die Zahl der verlorenen Bits beträgt bei einem Blockausfall $B=Z/F$. Es entsteht ein neuer Untercode der Rate: $R_u = {}^P/_{Z\text{-}b}$, wobei $P$ die Anzahl der Spalten in der Punktierungsmatrix **P** ist und somit die Periodenlänge der Punktierung angibt.

Der Interleaver bestimmt durch die Zuordnung der Bits zu den Blöcken des Kanals die Gestalt des Untercodes. Die Wahl des Interleavers muß so geschehen, daß die durch Blockausfall entstehenden Untercodes optimal im Sinne der beschriebenen Distanzkriterien sind. Nach der rechnergestützten Suche des Muttercodes der Rate ½ und des punktierten Codes der Rate 11/16 muß eine dritte Suche durchgeführt werden. Es müssen $F$ gute Punktierungsmatrizen für die Untercodes gesucht werden, deren Elemente immer Null sind, wenn die Punktierungsmatrix des Muttercodes an dieser Stelle eine Null enthält, und die an anderen Positionen nur dann eine Null enthalten dürfen, wenn keine andere Matrix eines Untercodes an dieser Stelle Null ist. Jedes Bit muß genau einem Zeitschlitz zugeordnet werden.

Für die Zuordnung des Codes der Rate 11/16 auf 4 Zeitschlitze ergeben sich folgende optimale Untercodes der Rate $R_u$=11/12.

$$P_{u1} = \begin{bmatrix} x & 1 & 1 & 1 & 1 & 1 & x & 1 & x & 1 & 1 \\ 1 & 0 & x & 0 & 1 & 0 & 1 & 0 & 1 & 0 & 0 \end{bmatrix}$$

$$P_{u2} = \begin{bmatrix} 1 & 1 & 1 & x & 1 & x & 1 & 1 & 1 & 1 & 1 \\ x & 0 & 1 & 0 & 1 & 0 & x & 0 & 1 & 0 & 0 \end{bmatrix}$$

$$P_{u3} = \begin{bmatrix} 1 & x & 1 & 1 & x & 1 & 1 & 1 & 1 & 1 & x \\ 1 & 0 & 1 & 0 & 1 & 0 & 1 & 0 & x & 0 & 0 \end{bmatrix}$$

$$P_{u4} = \begin{bmatrix} 1 & 1 & x & 1 & 1 & 1 & 1 & x & 1 & x & 1 \\ 1 & 0 & 1 & 0 & x & 0 & 1 & 0 & 1 & 0 & 0 \end{bmatrix}$$

Diese Untermatrizen lassen sich zu der kombinierten Punktierungs- und Interleavermatrix zusammenfassen:

$$P* = \begin{bmatrix} 1 & 3 & 4 & 2 & 3 & 2 & 1 & 4 & 1 & 4 & 3 \\ 2 & 0 & 1 & 0 & 4 & 0 & 2 & 0 & 3 & 0 & 0 \end{bmatrix}$$

Diese Matrix unterscheidet sich von der des Blockinterleavers aus (3.3). Die Distanzeigenschaften sind besser als die des Blockinterleavers. Die Distanzspektren der einzelnen Punktierungsmatrizen der Untercodes werden addiert, um den optimalen Code zu ermitteln.

Tabelle 3.1:

| Freie Distanz und Distanzspektrum des punktierten Codes der Rate 11/16. | | | | |
|---|---|---|---|---|
| $d_f = 4$ | $a_4 = 6$ | $c_4 = 18$ | $a_5 = 34$ | $c_5 = 132$ |

Tabelle 3.2:

| Freie Distanz und Distanzspektrum der Untercodes der Rate 11/12. | | | | | |
|---|---|---|---|---|---|
| Code mit $P_{u1}$: | $d_f = 2$ | $a_2 = 6$ | $c_2 = 21$ | $a_3 = 112$ | $c_3 = 556$ |
| Code mit $P_{u2}$: | $d_f = 2$ | $a_2 = 4$ | $c_2 = 15$ | $a_3 = 78$ | $c_3 = 441$ |
| Code mit $P_{u3}$: | $d_f = 2$ | $a_2 = 4$ | $c_2 = 16$ | $a_3 = 106$ | $c_3 = 661$ |
| Code mit $P_{u4}$: | $d_f = 2$ | $a_2 = 6$ | $c_2 = 26$ | $a_3 = 132$ | $c_3 = 807$ |
| Summe | | 20 | 78 | 428 | 2465 |

Im Vergleich dazu existiert beim Blockinterleaver ein Untercode mit einer minimalen Distanz $d_f = 1$. Dies führt zu einer höheren Fehlerrate.

In Fig. 1 sind die Blockfehlerraten des Halbratenkanals für den nach dem herkömmlichen Verfahren bestimmten Interleaver (gestrichelte Linie, bezeichnet mit "Regulär") bzw. des optimierten, durch die kombinierte Punktierungs- und Interleavermatrix nach Gleichung (3.5) beschriebenen Interleavers (durchgezogene Linie, bezeichnet mit "Optimal") gegenübergestellt. Bereits in diesem einfachen Beispiel ergibt sich ein Gewinn von 0,3 dB, der ohne zusätzlichen decoderseitigen Aufwand realisiert werden kann.

Fig. 2 zeigt einen Vergleich der Bitfehlerraten bei einem herkömmlichen Interleaver (Blockinterleaver - siehe in der Figur, die mit "old code" bezeichneten Kurven) und eines optimierten Interleavers (siehe in der Figur, die mit "new code" bezeichneten Kurven). Die Figur betrifft einen Halbratenkanal bei der Rate 8,1 kbit/s ("Modus 3H") und die in dem Kästchen angegebenen Coderaten und zeigt die Bitfehlerrate, aufgetragen über der Bitnummer.

Dabei wurde, um den ungleichen Fehlerschutz zu erzielen, mit folgenden Raten codiert:

Tabelle 1:

| Raten des Modus 3H mit Block- und optimiertem Interleaver | | | | | | | |
|---|---|---|---|---|---|---|---|
| Blockinterleaver | Bitnr. | 0..1 | 2..5 | 6..23 | 24..47 | 48..95 | 96..163 |
| | Anzahl | 2 | 4 | 18 | 24 | 48 | 68 |
| | Rate | 1/3 | 2/5 | 1/2 | 8/14 | 8/11 | 1 |
| Optimaler Inter1. | Bitnr. | 0..1 | 2..5 | 6..22 | 23..42 | 43..97 | 98..163 |
| | Anzahl | 2 | 4 | 17 | 20 | 55 | 66 |
| | Rate | 1/3 | 2/5 | 1/2 | 10/16 | 11/16 | 1 |

Untersuchungen der Erfinder haben ergeben, daß der mit dem vorgeschlagenen Verfahren erzielbare Gewinn umso größer ist, je höher die Rate des Codes ist. Auch eine Erhöhung der Anzahl $Z$ der Bits, die zusammengefaßt werden, führt zu einer Verbesserung der Distanzeigenschaften und damit einer Verringerung der zu erwartenden Bitfehlerrate.

**Patentansprüche**

1. Verfahren zur Kanalcodierung in einem digitalen Nachrichtenübertragungssystem, insbesondere von Sprachsignalen zur Sprachübertragung in einem Mobilfunksystem, wobei das Verfahren eine Fehlerschutzcodierung und eine Verschachtelung aufweist,
   **dadurch gekennzeichnet, daß**
   eine in einem gemeinsamen Berechnungsschritt bestimmte zusammenhängende Punktierungs- und Verschachtelungsvorschrift für eine Punktierung eines vorbestimmten Fehlerschutzcodierungs-Muttercodes und für die Verschachtelung angewandt wird, welche unter dem Kriterium einer Optimierung der Distanzeigenschaften nach der Verschachtelung bestimmt wird.

2. Verfahren nach Anspruch 1,
   **dadurch gekennzeichnet, daß**
   die Punktierungs- und Verschachtelungsvorschrift in Form einer Menge von Untercodes bzw. Punktierungstabellen angewandt wird.

3. Verfahren nach Anspruch 1 oder 2,
   **dadurch gekennzeichnet, daß**
   die Punktierungs- und Verschachtelungsvorschrift in Form einer kombinierten Punktierungs- und Verschachtelungsmatrix bzw. -tabelle angewandt wird.

4. Verfahren nach einem der vorangehenden Ansprüche,
   **dadurch gekennzeichnet, daß**

   (a) in einer Mehrzahl von Berechnungsschritten nach einer Mehrzahl vorgegebener Algorithmen eine Mehrzahl von zusammenhängenden Punktierungs- und Verschachtelungsvorschriften bestimmt wird,
   (b) in einem Bewertungsschritt durch Bestimmung einer freien Distanz und/oder eines mittleren Distanzspektrums deren Distanzeigenschaften ermittelt werden und
   (c) diejenige zusammenhängende Punktierungs- und Verschachtelungsvorschrift bei der Kanalcodierung angewandt wird, die die günstigste freie Distanz und/oder das günstigste Distanzspektrum liefert.

5. Verfahren nach einem der vorangehenden Ansprüche, **gekennzeichnet durch**
   die Anwendung auf einen Übertragungskanal mit annähernd konstanter Fadingamplitude innerhalb eines Zeitschlitzes und ein Übertragungsverfahren, bei dem jedem neuen Zeitschritt ein anderer Kanal zugeordnet wird.

6. Verfahren nach einem der vorangehenden Ansprüche, **gekennzeichnet durch**
   die Anwendung auf ein Sprachübertragungsverfahren mit blockweiser Codierung und mit Aufteilung der Rahmen auf wenige Zeitschlitze.

**EP 1 166 448 B1**

7. Verfahren nach einem der vorangehenden Ansprüche, **gekennzeichnet durch**
die Anwendung auf einen Übertragungskanal mit Hauptfehlerereignis Auslöschung innerhalb eines Zeitschlitzes.


**Claims**

1. Method for channel coding in a digital telecommunication system, in particular of speech signals for the purpose of speech transmission in a mobile radio system, the method having error protection coding and interleaving, **characterized in that** a coherent puncturation and interleaving rule determined in a common calculation step is applied for puncturation of a predetermined error protection coding master code and for interleaving, said rule being determined under the criterion of optimizing the distance properties after interleaving.

2. Method according to Claim 1, **characterized in that** the puncturation and interleaving rule is applied in the form of a set of subcodes or puncturation tables.

3. Method according to Claim 1 or 2, **characterized in that** the puncturation and interleaving rule is applied in the form of a combined puncturation and interleaving matrix or table.

4. Method according to one of the preceding claims, **characterized in that**

   (a) a plurality of coherent puncturation and interleaving rules are determined in a plurality of calculation steps using a plurality of predefined algorithms,
   (b) in one calculation step the determination of a free distance and/or a mean distance spectrum is used to determine the distance properties thereof, and
   (c) that coherent puncturation and interleaving rule is applied in channel coding which supplies the most favourable free distance and/or the most favourable distance spectrum.

5. Method according to one of the preceding claims, **characterized by** application to a transmission channel with an approximately constant fading amplitude within a timeslot, and a transmission method in which each new time step is assigned another channel.

6. Method according to one of the preceding claims, **characterized by** application to a speech transmission method with blockwise coding and with division of the frames into a few timeslots.

7. Method according to one of the preceding claims, **characterized by** application to a transmission channel with main error event extinction within a timeslot.


**Revendications**

1. Procédé de codage de canal dans un système de transmission numérique de message, en particulier de signaux vocaux pour la transmission vocale dans un système de radiotéléphonie mobile, le procédé comprenant un codage de protection contre les erreurs et un entrelacement, **caractérisé en ce que** pour le pointillage d'un code-maître prédéterminé pour le codage de protection contre les erreurs et pour l'entrelacement, on utilise une prescription combinée de pointillage et d'entrelacement définie dans une étape commune de calcul, qui est déterminée en fonction du critère d'une optimisation des propriétés de distance après l'entrelacement.

2. Procédé selon la revendication 1, **caractérisé en ce que** la prescription de pointillage et d'entrelacement est utilisée sous forme de sous-codes resp. de tableaux de pointillage.

3. Procédé selon la revendication 1 ou 2, **caractérisé en ce que** la prescription de pointillage et d'entrelacement est utilisée sous la forme d'une matrice resp. d'un tableau combiné de pointillage et d'entrelacement.

4. Procédé selon l'une des revendications précédentes, **caractérisé en ce que**

   (a) dans une pluralité d'étapes de calcul selon une pluralité d'algorithmes prédéterminés, on détermine une pluralité de prescriptions combinées de pointillage et d'entrelacement,
   (b) dans une étape d'évaluation, on détermine leurs propriétés de distance par détermination d'une distance libre et/ou d'un spectre de distance moyenne et

(c) on utilise pour le codage de canal la prescription combinée de pointillage et d'entrelacement qui fournit la distance libre la plus favorable et/ou le spectre de distance le plus favorable.

5. Procédé selon l'une des revendications précédentes, **caractérisé par** le recours à un canal de transmission qui présente une amplitude d'atténuation sensiblement constante à l'intérieur d'une fenêtre temporelle et un procédé de transmission dans lequel un autre canal est associé à chaque nouvelle fenêtre temporelle.

6. Procédé selon l'une des revendications précédentes, **caractérisé par** le recours à un procédé de transmission vocale avec codage par blocs et répartition des trames sur un petit nombre de fenêtres temporelles.

7. Procédé selon l'une des revendications précédentes, **caractérisé par** le recours à un canal de transmission dont te résultat des erreurs principales est un effacement à l'intérieur d'une fenêtre temporelle.

**FIG 1**

SNR in dB

Blockfehlerrate

Regulär

Optimal

EP 1 166 448 B1

FIG 2